# EUROPÄISCHE PATENTSCHRIFT

(11) **EP 2 854 238 B1**
(45) Veröffentlichungstag und Bekanntmachung des Hinweises auf die Patenterteilung: **04.05.2016**
(21) Anmeldenummer: 14197115.0
(22) Anmeldetag: 27.02.2009
(51) Int. Cl.: H01R 13/658, H01R 13/74, H05K 9/00

(54) **Hochfrequenz-Abdichtung von Hochfrequenz-Steckverbindern**
High frequency seal for high frequency connectors
Joint haute fréquence de raccords enfichables haute fréquence

(30) Priorität: 19.03.2008 DE 102008014888; 20.05.2008 DE 102008024300
(43) Veröffentlichungstag der Anmeldung: 01.04.2015
(62) Teilanmeldung aus: 09002853.1
(73) Patentinhaber: Rohde & Schwarz GmbH & Co. KG, 81671 München (DE)
(72) Erfinder: Hollrotter, Johann, 94447 Plattling (DE); Ullrich, Stefan, 82327 Tutzing (DE)
(74) Vertreter: Körfer, Thomas

(56) Entgegenhaltungen:
- US-A- 4 572 921
- US-A- 5 079 388
- US-A- 6 129 563
- US-A1- 2005 250 383

## Beschreibung

Die Erfindung betrifft eine Anordnung zur Hochfrequenz-Abdichtung eines Hochfrequenz-Steckverbinders in einem Abschirmgehäuse.

Für die Hochfrequenz (HF)-Verbindung an Baugruppen werden verschiedene genormte Steckverbindersysteme verwendet. Sehr häufig eingesetzte Steckverbinder sind zum Beispiel genormte SMA-Verbinder, die für einen Frequenzbereich von 1 GHz bis 26,5 GHz oder höher eingesetzt werden und deren Stecker mit einer Überwurfmutter an die mit einem Außengewinde versehenen Steckverbinder aufgeschraubt werden. Daneben sind SMP-Verbinder, die für einen Frequenzbereich von 50 Hz bis 40 GHz eingesetzt werden und als Steckverbindung ausgeführt sind, weit verbreitet. Für räumlich sehr kompakte Anwendungen, wie zum Beispiel den Anschluss von PCMCIA-Karten und einem Frequenzbereich bis 6 GHz sind MMCX-Steckverbinder in Gebrauch.

Üblicherweise sind HF-Baugruppen von einem metallischen Gehäuse umgeben, um die Umgebung von HF-Strahlung sowie eine Einstrahlung von außen abzuschirmen. Das Gehäuse besteht üblicherweise aus zwei Teilen, einer Bodenplatte in welche die HF-Baugruppe eingelegt ist und einer Abschirmhaube, die die HF-Baugruppe von der Gegenseite umschließt. Die Abschirmhaube wird mit der Bodenplatte fest verschraubt.
Um den an der Baugruppe angebrachten Steckverbinder aus dem Gehäuse nach außen zu führen, weist die Abschirmhaube bzw. die Bodenplatte eine Aussparung auf, durch die der Steckverbinder hindurchgeführt wird. Aufgrund von Bearbeitungstoleranzen bei der Gehäusebearbeitung ergibt sich ein Zwischenraum zwischen Steckverbinder und Gehäuse, sodass ein Leck in der HF-Abschirmung entsteht.
Eine HF-Abdichtung nach Stand der Technik ist z. B. in der Auslegeschrift DE 25 23 689 B2 beschrieben. Dort wird der Steckverbindersockel von einer Manschette aus elektrisch leitendem Gummi umschlossen und lösbar vor der Gehäusewand angebracht. Bei hergestellter Steckverbindung wird die Manschette, im Ausführungsbeispiel ein O-Ring, vom Steckergegenstück zusammengedrückt und dadurch die Verbindung hochfrequenzmäßig abdichtet. Der Druck der beiden Steckerteile gegeneinander wird dadurch erzeugt, dass die beiden, die Steckerteile tragenden Gehäuse miteinander fest verschraubt werden. In den meisten HF-Anordnungen werden die beiden Teile des Steckverbinders nicht aneinandergedrückt, sodass die in der DE 25 23 689 B2 beschriebene Lösung nicht angewendet werden kann.

Das Dokument US2005/0250383 offenbart eine Anordnung gemäss dem Oberbegriff des Anspruchs 1. Eine theoretische Möglichkeit dieses Leck nach Stand der Technik abzudichten, besteht darin eine Dichtschnur aus leitfähigem Material in die Aussparung der Abschirmhaube zu kleben. Der eingesetzte Stecker drückt die Dichtmatte zusammen und schließt so der Zwischenraum zwischen Gehäuseaussparung und Steckverbinder HF-dicht ab. Der Nachteil dieser Lösung liegt darin, dass die Dichtschnur per Hand in die Aussparung eingebracht werden muss. Dies ist zeitintensiv und erzeugt hohe Fertigungskosten. Desweiteren ist die Langzeitstabilität nicht befriedigend. Die Dichtschnur verrutscht leicht, verliert durch Umwelteinflüsse die elektrische Leitfähigkeit und an Elastizität.
Es ist daher die Aufgabe der Erfindung, eine Anordnung zur HF-Abdichtung eines Steckverbinders in einem Abschirmgehäuse zu finden, die einen schnellen und kostengünstigen Einbau des Steckverbinders in das Abschirmgehäuse erlaubt und eine hohe Langzeitstabilität gewährleistet.

Die Aufgabe wird durch eine erfindungsgemäße Anordnung zur Hochfrequenz-Abdichtung nach Anspruch 1 gelöst. In den Unteransprüchen sind vorteilhafte Weiterbildungen der erfinderischen Anordnung dargestellt.

Die Erfindung besteht darin, den Zwischenraum zwischen einem Steckverbinder und einem Gehäuse mit einem elektrisch leitendem Abdichtmaterial, Hochfrequenz - dicht abzuschließen, wobei der Steckverbinder aus einem Steckeranschlussbereich und einem Gehäusebefestigungsbereich besteht und der Gehäusebefestigungsbereich in einer Aussparung des Gehäuses eingesetzt ist.

Erfindungsgemäß ist im Gehäusebefestigungsbereich des Steckverbinders mindestens eine Nut in radialer Richtung ausgebildet, die in umfänglicher Richtung mindestens teilweise den Gehäusebefestigungsbereich des Steckverbinders umgibt, wobei das HF-Abdichtmaterial in die Nut im Gehäusebefestigungsbereich des Steckverbinders unverrückbar eingebracht ist.

Vorteilhaft ist es, dass die mindestens eine Nut in axialer Richtung die Enden des Gehäusebefestigungsbereichs aussparen und somit an den Enden einen Überstand ausbilden und der Abstand zwischen den der Nut zugewandten Seiten der Überstände mindestens der Stärke der Gehäusewand entspricht.

Der mit dem HF-Abdichtmaterial versehene Steckverbinder wird vorzugsweise mit Druck gegen die Vorspannung des HF-Abdichtmaterials in die Aussparung der Abschirmhülle eingesetzt und verschließt den Zwischenraum zwischen Steckverbinder und Gehäuse vollständig.

Vorteilhaft ist es, als Abdichtmaterial eine oder mehrere metallische Federn oder eine oder mehrere elektrisch leitende Kunststoffmatten zu verwenden. Die metallischen Federn werden vorteilhafter Weise mit einem gut leitenden Material, zum Beispiel Gold oder Silber, beschichtet, sodass eine hohe elektrische Oberflächenleitfähigkeit gewährleistet ist.

Ausführungsbeispiele der erfindungsgemäßen Anordnung sind in den Zeichnungen dargestellt und werden anhand der nachfolgenden Beschreibung näher erläutert. Es zeigen:
- Fig.1: einen für die erfindungsgemäße Anordnung geeigneten Steckerverbinder in schematischer Seitenansicht;
- Fig.2: eine Vorderansicht des in Fig.1 dargestellten Steckerverbinders;
- Fig.3: ein erstes Ausführungsbeispiel der erfindungsgemäßen Anordnung eines mittels einer elektrisch leitenden Kunststoffmatte HF-dicht eingebauten Steckverbinders in ein Abschirmhaube;
- Fig.4: eine detaillierte perspektivische Aussicht der Anordnung entsprechend Fig.3;
- Fig.5: ein zweites Ausführungsbeispiel der erfindungsgemäßen Anordnung eines mittels einer metallischen Feder mit Blattfedern HF-dicht eingebauten Steckverbinders in detaillierter perspektivischer Aussicht;
- Fig.6: eine Detailansicht einer metallischen Feder mit Blattfedern, wie in Fig.5 verwendet und
- Fig.7: ein drittes Ausführungsbeispiel der erfindungsgemäßen Anordnung eines Steckverbinders, der mittels zweier metallischen Feder mit gezackten Federelementen HF-dicht eingebaut ist, in detaillierter perspektivischer Aussicht und
- Fig.8: ein viertes Ausführungsbeispiel der erfindungsgemäßen Anordnung eines Steckverbinders, der mittels einer metallischen Feder mit gezackten Federelementen HF-dicht eingebaut ist, in detaillierter perspektivischer Aussicht.

Einander entsprechende Teile sind in allen Figuren mit den gleichen Bezugszeichen versehen.

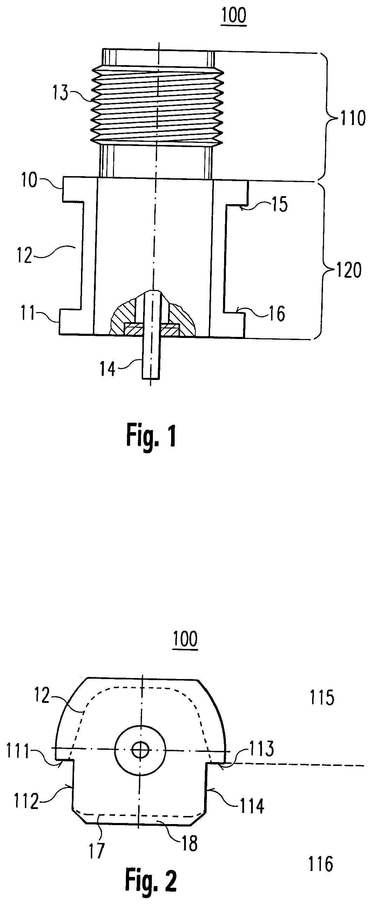

Fig.1 zeigt die Draufsicht auf einen Steckverbinder 100, der erfindungsgemäß typischerweise für die Verbindung von einer HF-Baugruppe nach außen verwendet wird. Er besteht aus einem Steckeranschlussbereich 110, der aus dem Abschirmgehäuse nach außen ragt und den Stecker eines Anschlusskabels aufnimmt und einem Gehäusebefestigungsbereich 120, der in elektrischem Kontakt mit der HF-Baugruppe steht und im Gehäuse verankert ist.

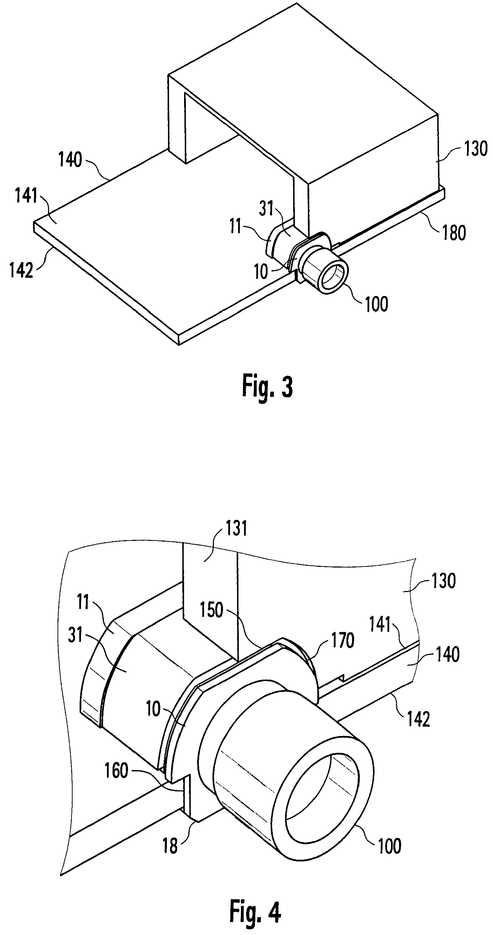

Der Steckeranschlussbereich 110 kann beispielsweise ein Gewinde aufweisen, an dem mittels einer Überwurfmutter der Stecker des Anschlusskabels befestigt ist oder als Ring zur Aufnahme eines Schnappverbinders ausgebildet sein. Der Innenleiter 14 des Steckverbinders, ragt über Gehäusebefestigungsbereich 120 hinaus und nimmt die elektrische Zuleitung zur HF-Baugruppe auf. Im Ausführungsbeispiel ist der Gehäusebefestigungsbereich 120 des Steckverbinders in einer Aussparung 160 der die HF-Baugruppe tragenden Platine 140 so angebracht, dass der Innenleiter 14 des Steckverbinders auf Höhe der Oberseite der Platine 140 liegt und die elektrische Zuleitung auf gleicher Höhe aufnimmt. Dies ist in Fig. 4 näher dargestellt. Der über die Platine 140 hochragende Teil 115 des Gehäusebefestigungsbereichs 120 des Steckverbinders 100 ist dafür breiter ausgeführt als die Aussparung 160 der Platine 140 und der in die Platine 140 hineinragende Teil 116 des Gehäusebefestigungsbereichs 120 des Steckverbinders 100 und liegt somit in passender Höhe auf der Platine 140 auf. Typischerweise ragt der in die Platine 140 eingesenkte schmale Teil 116 des Gehäusebefestigungsbereichs 120 des Steckverbinders 100 nur wenig über die der Baugruppe abgewandten Seite 142 der Platine hervor. Dies ist in Fig. 2 näher dargestellt.

Um die Umgebung von HF-Strahlung sowie die HF-Baugruppe von Strahlung von außen abzuschirmen, ist die HF-Baugruppe von einem metallischen Gehäuse 180 umgeben, was in Fig. 3 dargestellt ist. Das Gehäuse besteht aus einer Bodenplatte (nicht dargestellt), in welche die HF-Baugruppe eingelegt ist, und einer Abschirmhaube 130, die die HF-Baugruppe von der Gegenseite umschließt. Die Abschirmhaube 130 wird im Ausführungsbeispiel mit der Platine 140 und der Bodenplatte fest verschraubt.

Um den Steckverbinder 100 aus dem Gehäuse 180 nach außen zu führen, weisen die Abschirmhaube 130 und die Bodenplatte eine Aussparung 150 auf, durch die der Steckverbinder 100 hindurchgeführt wird. Aufgrund von Bearbeitungstoleranzen bei der Gehäusebearbeitung ergibt sich ein Zwischenraum 170 zwischen Steckverbinder 100 und Gehäuse 180. Um diesen Zwischenraum 170 HF-dicht abzuschließen, wird erfindungsgemäß eine Nut bzw. zwei Nute 12 und 17 in den Gehäusebefestigungsbereich 120 des Steckverbinders 100 eingearbeitet. Die Nut 12 umgibt in umfänglicher Richtung den über die Platinenoberseite 141 hochragende Teil 115 des Gehäusebefestigungsbereichs 120 des Steckverbinders 100. Die Nut 17 umfasst den über die gegenüberliegende Seite der Platine 141 hervorragenden Teil 18 des Gehäusebefestigungsbereichs 120 des Steckverbinders 100. Die Breite der Nute 12 und 17 in axialer Richtung entspricht mindestens der Dicke der Abschirmhaube 130 bzw. der Bodenplatte und ist im Gehäusebefestigungsbereich 120 des Steckverbinders 100 so positioniert, dass sich an den Enden des Gehäusebefestigungsbereichs jeweils ein flanschartiger Überstand 10 bzw. 11 ausbildet.

Zur HF-Abdichtung ist das elektrisch leitende Material in die Nute 12 und 17 unverlierbar eingelegt. Fig. 3 und 4 zeigen die erfindungsgemäße Anordnung bei Verwendung einer elektrisch leitenden Kunststoffmatte 31. Diese wird auf die Länge und Breite der Nut zugeschnitten und in die Nut 12 und 17 z. B. eingeklebt oder anders fixiert.

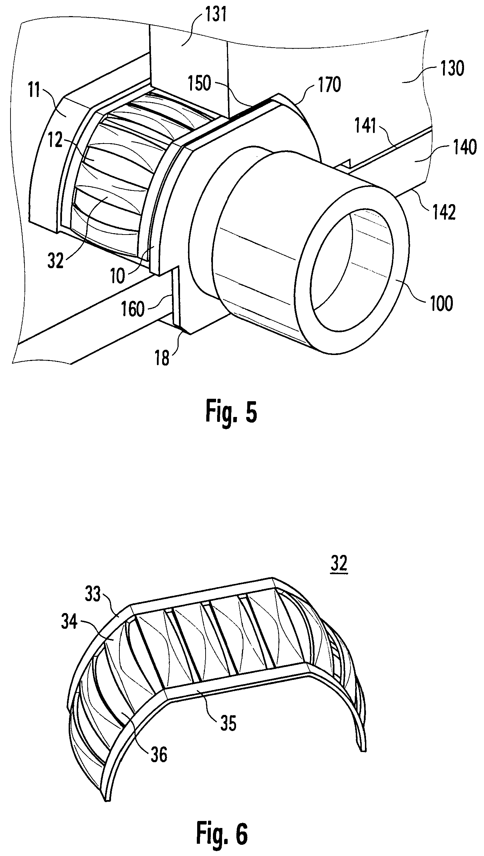

Ein weiteres vorteilhaftes Abdichtmaterial stellt eine metallische Feder 32 in Form eines Federbandes, wie in Fig.5 bis Fig.8 gezeigt, dar. Das Federband 32 in Fig. 6 besteht aus bezüglich ihrer Längsachse parallel nebeneinander angeordneten Blattfedern 34. Die einzelnen Blattfedern 34 sind an ihren oberen bzw. unteren Enden über jeweils ein kragenartiges metallisches Verbindungselement 33, 35 miteinander verbunden. Zur besseren Leitfähigkeit ist das Federband 32 bevorzugt mit einem sehr gut leitenden Material beschichtet, zum Beispiel mit Gold oder Silber bedampft. Die Breite des Federbandes ergibt sich aus der Länge der vorgespannten Blattfedern 34 und der Breite der beiden Verbindungselemente 33, 35 an den Enden und entspricht im Wesentlichen der Breite der Nut 12 im Gehäusebefestigungsbereich des Steckverbinders.

Das Federband 32 kann zum Beispiel aus einem wenige zehntel Millimeter starken, mit Gold beschichteten Metallband hergestellt werden, aus dem im regelmäßigen Abstand schmale Rechtecke 36 ausgestanzt sind. Die Rechtecke 36 sind mit ihrer langen Seite senkrecht zur Längsachse des Metallbands 32 ausgerichtet und zentriert und erstrecken sich über einen Großteil der Bandbreite. Die verbleibenden Metallstreifen 34 werden bogenförmig vorgeformt und bilden so Blattfedern aus. Die verbleibenden Randstreifen 33 und 35 dienen als Verbindungselement zwischen den einzelnen Blattfedern 34.

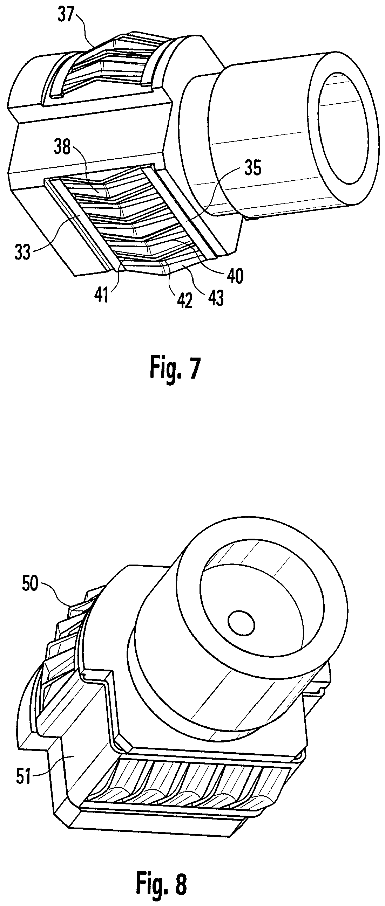

Eine weitere vorteilhafte Ausführung des Federbandes ist in Fig. 7 aufgezeigt und weist Federelemente 40 mit Zacken auf, die Kontakt auch bei Oberflächen mit schlechterer Leitfähigkeit herstellen können. Dazu wird ein Federband wie bereits bei Fig. 6 beschrieben gefertigt, die verbleibenden Metallstreifen 34 werden nun aber in der Mitte der Längsseite hochgebogen, wobei die Randbereiche 41, 43 höher als der Mittelbereich 42 aufgestellt sind und somit Zacken ausbilden.

Das Federband kann auch in Ätztechnik einstückig hergestellt werden, insbesondere, wenn das Federband aus Kupferberyllium besteht.

Zwei Federbänder 37, 38 werden auf die Länge der Nut 12 bzw. 17 gekürzt, der Form der Nut 12 bzw. 17 im Gehäusebefestigungsbereich 120 des Steckverbinders 100 angepasst und in die Nute 12 bzw. 17 so eingebracht, dass die Randstreifen in der Nut liegen und die Krümmung der Blattfedern 34 bzw. die Zacken des Federelements 40 zur Gehäuseaussparung 150 hin zeigt.

Fig. 8 zeigt eine Ausführungsvariante der HF-Abdichtung des Steckverbinders mit einem einteiligen Federband. Das Federband 50 schmiegt sich um den gesamten Gehäusebefestigungsteil 120 des Steckverbinders 100, wobei das Federband 50 an den Kontaktflächen 111, 112 und 113, 114 zur Platine 140 als glattes Metallband 51 ohne Blattfeder oder als Federelement mit Zacken ausgebildet ist. Das Federband 50 besitzt eine Trennstelle, die eine einfache Montage zu ermöglicht.

Die Federbänder 37 und 38 bzw. das Federband 50 werden beispielsweise mittels Punkt- oder Laserschweißung in der Nut befestigt oder ohne zusätzliches Verbindungsmittel aufgeschnappt. Das Federband 32 sollte günstigerweise bereits im Laufe des Herstellungsprozesses des Steckverbinders 100 gefertigt und aufgebracht werden und vom Hersteller des Steckverbinders 100 bestückungsfertig mitgeliefert werden.

Statt ein mit Gold beschichtetes Metallband als Ausgangsprodukt zu verwenden, kann die Goldschicht auch auf das fertige Federband aufgedampft oder aufgesputtert werden.

Der mit Federbändern 32 bestückte Steckverbinder 100 wird in die Aussparung 160 der Platine 140 der HF-Baugruppe wie bereits beschrieben eingebaut. Die Aussparung 150 der Abschirmhaube 130 bzw. Bodenplatte sitzt auf der Dichtmatte 31 bzw. dem Federband 32 des Steckverbinders auf, stellt einen umfassenden elektrisch leitenden Kontakt zwischen Steckverbinder 100 und Gehäuse 130 her und schließt den Steckerauslass HF-dicht ab.

## Patentansprüche

1. Anordnung zur HF-Abdichtung des Zwischenraumes (170) zwischen einem Steckverbinder (100) und einem Gehäuse (180) mit einem elektrisch leitendem HF-Abdichtelement (31), umfassend einen Steckverbinder und eine Platine,
wobei als HF-Abdichtelement (31) eine oder mehrere elektrisch leitende Kunststoffmatten (31) vorgesehen sind,
wobei der Steckverbinder (100) fest mit einer Platine (140) verbunden ist und diese Platine (140) von einer Gehäusehaube (130) und einer Gehäusebodenplatte umschlossen ist,
und wobei der Steckverbinder (100) aus einem Steckeranschlussbereich (110) und einem Gehäusebefestigungsbereich (120) besteht und der Gehäusebefestigungsbereich (120) in eine Aussparung des Gehäuses (180) eingesetzt ist,
**dadurch gekennzeichnet,**
**dass** im Gehäusebefestigungsbereich (120) des Steckverbinders (100) mindestens eine Nut (12, 17) in radialer Richtung ausgebildet ist, die in umfänglicher Richtung mindestens teilweise den Gehäusebefestigungsbereich (120) des Steckverbinders (100) umgibt, wobei das HF-Abdichtelement (31) unverrückbar in die Nut (12) im Gehäusebefestigungsbereich (120) des Steckverbinders eingebracht ist.

2. Anordnung nach Anspruch 1,
**dadurch gekennzeichnet,**
**dass** die mindestens eine Nut (12, 17) in axialer Richtung die Enden des Gehäusebefestigungsbereich (120) ausspart und somit an den Enden ein Überstand (10, 11) ausbildet und dass der Abstand zwischen den der Nut zugewandten Seiten (15, 16) der Überstände (10, 11) mindestens der Stärke der Gehäusewand (131) entspricht.

3. Anordnung nach einem der Ansprüche 1 bis 2,
**dadurch gekennzeichnet,**
**dass** das Gehäuse (130) auf dem HF-Abdichtelement (31) aufsitzt und dieses mit Druck kontaktiert.

4. Anordnung nach Anspruch 1 oder 3,
**dadurch gekennzeichnet,**
**dass** die zur HF-Abdichtung verwendete elektrisch leitende Kunststoffmatte (31) passgenau an die Form der Nut (12, 17) des Gehäusebefestigungsbereichs (120) des Steckverbinders (100) angepasst ist.

5. Anordnung nach einem der Ansprüche 1 bis 4,
**dadurch gekennzeichnet,**
**dass** der Steckverbinder (100) beispielsweise vom Typ SMA, QMA, SMP oder MMCX ist.

## Claims

1. Arrangement for high frequency sealing of the space (170) between a connector (100) and a housing (180) with an electrically conducting high frequency sealing element (31), comprising a connector and a printed circuit board, wherein one or more electrically conducting plastic mats (31) are provided as high frequency sealing element (31), wherein the connector (100) is connected firmly with a printed circuit board (140) and this printed circuit board (140) is enclosed by a housing cover (130) and a housing base plate,
and wherein the connector (100) consists of a connector connecting region (110) and a housing fastening region (120) and the housing fastening region (120) is inserted in an opening in the housing (180),
**characterised in that**
at least one slot (12, 17) is formed in the radial direction in the housing fastening region (120) of the connector (100), which slot at least partly surrounds the housing fastening region (120) of the connector (100) in the circumferential direction, wherein the high frequency sealing element (31) is fitted immovably into the slot (12) in the housing fastening region (120) of the connector.

2. Arrangement according to claim 1,
**characterised in that**
the at least one slot (12, 17) in the axial direction forms an opening in the ends of the housing fastening region (120) and thus forms a protrusion (10, 11) at the ends,
and **in that** the distance between the sides (15, 16) of the protrusions (10, 11) facing the slot corresponds to at least the thickness of the housing wall (131).

3. Arrangement according to one of claims 1 to 2,
**characterised in that**
the housing (130) sits on the high frequency sealing element (31) and contacts this with pressure.

4. Arrangement according to claim 1 or 3,
**characterised in that**
the electrically conducting plastic mat (31) used for the high frequency sealing is matched to the shape of the slot (12, 17) of the housing fastening region (120) of the connector (100) with a precise fit.

5. Arrangement according to one of claims 1 to 4,
**characterised in that**
the connector (100) is for example of the SMA, QMA, SMP or MMCX type.

## Revendications

1. Agencement pour assurer l'étanchéité aux hautes fréquences de l'espace intermédiaire (170) entre un connecteur à enfichage (100) et un boitier (180) à l'aide d'un élément d'étanchéité hautes-fréquences (31) électriquement conducteur, comprenant un connecteur à enfichage et une platine, agencement
dans lequel sont prévus, en guise d'élément d'étanchéité hautes-fréquences (31), un ou plusieurs mats ou nattes de matière plastique (31) électriquement conducteurs, dans lequel le connecteur à enfichage (100) est relié de manière fixe à une platine (140) et cette platine (140) est entourée ou enfermée par un capot de boitier (130) et une plaque de fond de boitier,
et dans lequel le connecteur à enfichage (100) est constitué d'une zone de branchement de connecteur (110) et d'une zone de fixation au boitier (120), et la zone de fixation au boitier (120) est insérée dans un évidement du boitier (180),
**caractérisé**
**en ce que** dans la zone de fixation au boitier (120) du connecteur à enfichage (100) est réalisée au moins une rainure (12, 17) en direction radiale, qui, en direction périphérique, entoure au moins partiellement la zone de fixation au boitier (120) du connecteur à enfichage (100), l'élément d'étanchéité hautes-fréquences (31) étant placé de manière non déplaçable dans la rainure (12) de la zone de fixation au boitier (120) du connecteur à enfichage.

2. Agencement selon la revendication 1,
**caractérisé**
**en ce que** ladite au moins une rainure (12, 17) réserve, en direction axiale, les extrémités de la zone de fixation au boitier (120), et forme ainsi aux extrémités, une partie en saillie (10, 11), et
**en ce que** la distance entre les faces (15, 16) des parties en saillie (10, 11), qui sont dirigées vers la rainure, correspond au moins à l'épaisseur de la paroi de boitier (131).

3. Agencement selon l'une des revendications 1 à 2,
**caractérisé**
**en ce que** le boitier (130) repose sur l'élément d'étanchéité hautes-fréquences (31) et est en contact par compression, avec celui-ci.

4. Agencement selon la revendication 1 ou la revendication 3,
**caractérisé**
**en ce que** le mat ou la natte de matière plastique (31) électriquement conducteur, utilisé pour assurer l'étanchéité aux hautes-fréquences, est adapté de manière précisément ajustée à la forme de la rainure (12, 17) de la zone de fixation au boitier (120) du connecteur à enfichage (100).

5. Agencement selon l'une des revendications 1 à 4,
**caractérisé**
**en ce que** le connecteur à enfichage (100) est par exemple du type SMA, QMA, SMP ou MMCX.
